# EUROPÄISCHE PATENTSCHRIFT

(11) **EP 2 205 774 B1**
(45) Veröffentlichungstag und Bekanntmachung des Hinweises auf die Patenterteilung: **22.07.2015**
(21) Anmeldenummer: 08805205.5
(22) Anmeldetag: 10.10.2008
(51) Int. Cl.: C23C 30/00, C23C 16/02, C23C 16/34

(54) **HARTSTOFFBESCHICHTETE KÖRPER UND VERFAHREN ZU DEREN HERSTELLUNG**
BODIES COATED WITH A HARD MATERIAL AND METHOD FOR THE PRODUCTION THEREOF
CORPS RECOUVERTS D'UNE SUBSTANCE DURE ET LEUR PROCÉDÉ DE PRODUCTION

(30) Priorität: 16.10.2007 DE 102007000512
(43) Veröffentlichungstag der Anmeldung: 14.07.2010
(73) Patentinhaber: Fraunhofer-Gesellschaft zur Förderung der angewandten Forschung e.V., 80686 München (DE)
(72) Erfinder: ENDLER, Ingolf, 01640 Coswig (DE); HÖHN, Mandy, 01277 Dresden (DE)
(74) Vertreter: Rauschenbach, Dieter
(86) Internationale Anmeldenummer: PCT/EP2008/063583
(87) Internationale Veröffentlichungsnummer: WO 2009/050110

(56) Entgegenhaltungen:
- DE-A1-102005 032 860
- ENDLER I ET AL: "Aluminum-rich Ti1-xAlxN coatings by CVD" PM IN BELGIUM, A CROSSROADS IN INDUSTRY DEVELOPMENT: EURO PM 2006 CONGRESS & EXHIBITION; 23 - 25 OCTOBER 2006, GHENT, BELGIUM, PROCEEDINGS, POWDER METALLURGY CONGRESS & EXHIBITION, EUROPEAN POWDER METALLURGY ASSOCIATION, SHREWSBURY, Bd. 1, 25. Oktober 2006 (2006-10-25), Seiten 219-224, XP008105516 ISBN: 978-1-899072-32-3 in der Anmeldung erwähnt

## Beschreibung

### Technisches Gebiet

Die Erfindung betrifft hartstoffbeschichtete Körper mit einem mehrlagigen Schichtsystem, das mindestens eine Ti₁₋ₓAlₓN-Hartstoffschicht enthält, und ein Verfahren zu deren Herstellung. Die erfindungsgemäße Beschichtung kann insbesondere bei Werkzeugen und Bauteilen aus Stahl, Hartmetallen, Cermets und Keramiken eingesetzt werden, wie beispielsweise bei Bohrern, Fräsern und Wendeschneidplatten. Die erfindungsgemäß beschichteten Körper weisen eine verbesserte Verschleißfestigkeit auf.

### Stand der Technik

Die Herstellung von Verschleißschutzschichten in bestimmten Bereichen des Materialsystems Ti-Al-N ist entsprechend der WO 03/085152 A2 bereits bekannt. Dabei ist es möglich, monophasige TiAIN-Schichten mit der NaCl-Struktur bei AIN-Gehalten bis 67% herzustellen. Solche kubischen TiAIN-Schichten besitzen eine relativ hohe Härte und Verschleißfestigkeit. Bei AIN-Gehalten > 67% entsteht allerdings ein Gemisch aus kubischem und hexagonalem TiAlN und bei einem AIN-Anteil > 75% nur noch die weichere und nicht verschleißfeste hexagonale Wurtzitstruktur.

Es wurde auch bereits gefunden, dass mittels Plasma-CVD einphasige Ti₁₋ₓAlₓN-Hartstoffschichten mit x bis 0,9 herstellbar sind (R. Prange, Diss. RTHW Aachen, 1999, Fortschritt-Berichte VDI, 2000, Reihe 5, Nr. 576 sowie O. Kyrylov et al., Surface and Coating Techn. 151-152 (2002) 359-364). Nachteilig hierbei sind jedoch die unzureichende Homogenität der Schichtzusammensetzung und der relativ hohe Chlorgehalt in der Schicht. Außerdem ist die Verfahrensdurchführung kompliziert und aufwändig.

Für die Herstellung der bekannten Ti₁₋ₓAlₓN-Hartstoffschichten werden nach dem Stand der Technik PVD- oder Plasma-CVD-Verfahren eingesetzt, die bei Temperaturen unter 700°C betrieben werden (A. Hörling, L. Hultman, M. Oden, J. Sjölen, L. Karlsson, J. Vac. Sci. Technol. A 20 (2002)5, 1815 - 1823 sowie D. Heim, R. Hochreiter, Surface and Coatings Technology 98 (1998) 1553 - 1556). Nachteilig bei diesen Verfahren ist, dass die Beschichtung komplizierter Bauteilgeometrien Schwierigkeiten bereitet. PVD ist ein sehr gerichteter Prozess und Plasma-CVD erfordert eine hohe Plasmahomogenität, da die Plasmaleistungsdichte direkten Einfluss auf das Ti/Al-Atomverhältnis der Schicht hat. Mit den industriell fast ausschließlich eingesetzten PVD-Verfahren ist es nicht möglich, einphasige kubische Ti₁₋ₓAlₓN-Schichten mit x > 0,75 herzustellen.

Da es sich bei kubischen TiAIN-Schichten um eine metastabile Struktur handelt, ist eine Herstellung mit konventionellen CVD-Verfahren bei hohen Temperaturen ≥ 1000°C prinzipiell nicht möglich, weil bei Temperaturen oberhalb 1000°C ein Gemisch aus TiN und hexagonalem AIN entsteht.

Entsprechend der US 6,238,739 B1 ist es auch bekannt, dass durch einen thermischen CVD-Prozess ohne Plasmaunterstützung Ti₁₋ₓAlₓN-Schichten mit x zwischen 0,1 und 0,6 im Temperaturbereich zwischen 550°C und 650°C erhältlich sind, wenn eine Gasmischung von Aluminium- und Titanchloriden sowie NH₃ und H₂ verwendet wird. Der Nachteil dieses speziellen thermischen CVD-Verfahrens besteht ebenfalls in der Eingrenzung auf eine Schichtstöchiometrie x ≤ 0,6 und der Beschränkung auf Temperaturen unter 650°C. Die geringe Beschichtungstemperatur führt zu hohen Chlorgehalten in der Schicht bis 12 At.%, die für die Anwendung schädlich sind (S. Anderbouhr, V. Ghetta, E. Blanquet, C. Chabrol, F. Schuster, C. Bernard, R. Madar, Surface and Coatings Technology 115 (1999) 103 - 110).

Um die hohen Anforderungen als Verschleißschutzschicht auf Werkzeugen und Bauteilen zu erfüllen, muss eine extrem gute Haftung gewährleistet sein. Bei PVD-TiAIN-Schichten wird als haftungsverbessernde Schicht häufig TiN verwendet. Die Kombination einer ersten TiN-Schicht mit einer nachfolgend aufgebrachten TiAlN-Schicht ist in der Literatur beschrieben (S.G. Harris, E.D. Doyle, A.C. Vlasveld, J. Audy, D. Quick; Wear 254 (2003) S. 723-734).

Weiterhin sind auch Schichtsysteme bekannt, bei denen TiAIN-Einzelschichten mit unterschiedlichem Ti/Al-Verhältnis miteinander kombiniert werden bzw. eine Schicht mit einem Ti/Al-Konzentrationsgradienten erzeugt wird. So wird in der DE 44 08 250 C2 eine Kombination von zwei TiAIN-Schichten mit unterschiedlicher Zusammensetzung beschrieben, um eine verbesserte Haftung zu erzielen. Dabei werden mittels plasmagestützter CVD-Abscheidung zwei TiAIN-Schichten aufgebracht, wobei die erste titanreichere Schicht direkt auf dem Substrat abgeschieden wird und die zweite Schicht, die einen höheren Al-Gehalt aufweist, auf der ersten Schicht angeordnet wird. Alternativ wird eine TiAIN-Schicht erzeugt, bei der Ti und Al in einer sich graduell verändernden Zusammensetzung vorliegen. Von der Grenzfläche zwischen Substrat und Schicht in Richtung Oberfläche des Films nimmt der Ti-Gehalt allmählich ab und der Al-Gehalt allmählich zu.

Bekannt sind auch mittels CVD oder PACVD erzeugte Schichten und Mehrlagenschichten aus Ti₁₋ₓAlₓN, bei denen die Schichten einen kontinuierlichen Konzentrationsgradienten des Al aufweisen (US 6,040,012; DE 699 15 866 T2). Diese Ti₁₋ₓAlₓN-Konzentrationsschichten sind auf eine Al-Konzentration mit einem x bis maximal 0,6 beschränkt. Der begrenzte Al-Gehalt führt zu einer nur mäßigen Oxidationsbeständigkeit und wirkt sich damit nachteilig auf die Verschleißbeständigkeit bei hoher thermischer Belastung während des Werkzeugeinsatzes aus.

Es sind auch bereits hartstoffbeschichtete Körper bekannt, die mit mindestens einer mittels CVD ohne Plasmaanregung erzeugten Ti₁₋ₓAlₓN-Hartstoffschicht beschichtet sind, welche als einphasige Schicht in der kubischen NaCl-Struktur mit einem Stöchiometriekoeffizienten x > 0,75 bis x = 0,93 und einer Gitterkonstante a_{fcc} zwischen 0,412 nm und 0,405 nm vorliegt oder die eine mehrphasige Ti₁₋ₓAlₓN-Hartstoffschicht ist, deren Hauptphase aus Ti₁₋ₓAlₓN mit kubischer NaCl-Struktur mit einem Stöchiometriekoeffizienten x > 0,75 bis x = 0,93 und einer Gitterkonstante a_{fcc} zwischen 0,412 nm und 0,405 nm besteht (DE 10 2005 032 860 B4). Als weitere Phase ist dabei Ti₁₋ₓAlₓN in Wurtzitstruktur und/oder als TiNₓ in NaCl-Struktur enthalten. Diese hartstoffbeschichteten Körper weisen eine gute Verschleißfestigkeit und Oxidationsbeständigkeit auf.

Bei TiAIN-Schichten, die mittels thermischem CVD bei deutlich höheren Temperaturen im Bereich zwischen 700°C und 900°C hergestellt werden, ist bisher nur die bereits oben genannte TiN-Zwischenschicht beschrieben worden (I. Endler, M. Herrman, M. Naupert, R. Pitonak, M. Schneider, H. van den Berg, H. Westphal; Proceedings Euro PM2006, Ghent, Belgium, 23.-25. October 2006, Vol. 1, S. 219-224).

### Offenbarung der Erfindung

Der Erfindung liegt die Aufgabe zugrunde, bei hartstoffbeschichteten Körpern mit einem mehrlagigen Schichtsystem, das mindestens eine Ti₁₋ₓAlₓN-Hartstoffschicht enthält, eine sehr gute Haftung der Ti₁₋ₓAlₓN-Hartstoffschicht bei hoher Verschleißfestigkeit zu erreichen.

Diese Aufgabe wird mit den Merkmalen der Patentansprüche gelöst.

Die erfindungsgemäßen hartstoffbeschichteten Körper mit einem mehrlagigen Schichtsystem, das mindestens eine Ti₁₋ₓAlₓN-Hartstoffschicht enthält, sind dadurch gekennzeichnet, dass das Schichtsystem besteht aus
a) einer auf den Körper aufgebrachten Anbindungsschicht aus TiN, Ti(C,N) oder TiC,
b) einer auf der Anbindungsschicht aufgebrachten Phasengradientenschicht und
c) der/den darauf aufgebrachten ein- oder mehrphasigen Ti₁₋ₓAlₓN-Hartstoffschicht(en),
wobei die Phasengradientenschicht an ihrer der Anbindungsschicht zugewandten Seite aus einem TiN/h-AIN-Phasengemisch besteht und in Richtung zur/zu den Ti₁₋ₓAlₓN-Hartstoffschicht(en) mit zunehmender Schichtdicke einen zunehmenden Phasenanteil von fcc-TiAIN mit einem Anteil von > 50% und damit einhergehender simultaner Abnahme der Phasenanteile von TiN und h-AlN aufweist.

Dabei enthalten mehrphasige Ti₁₋ₓAlₓN-Hartstoffschichten als Hauptphase fcc-Ti₁₋ₓAlₓN, wobei als weitere Phasen Ti₁₋ₓAlₓN in Wurtzitstruktur und/oder TiN enthalten sind.

Vorteilhafterweise weist die Phasengradientenschicht über ihre Dicke einen konstanten oder nahezu konstanten Gehalt an Ti, Al und N auf.

Die Phasengradientenschicht weist vorzugsweise eine Dicke im Bereich von 0,1 µm bis 5 µm und ein Atomverhältnis von Ti:Al im Bereich von 1:1 bis 1:15 auf.

Das auf den Körpern erfindungsgemäß vorhandene Schichtsystem zeichnet sich durch eine deutlich höhere Haftfestigkeit aus im Vergleich zu einem Schichtsystem, das keine Phasengradientenschicht enthält. Die Phasengradientenschicht ermöglicht weiterhin eine gute Anpassung von verschiedenen Schichteigenschaften wie Härte und Eigenspannung. Durch die erfindungsgemäße Schichtfolge wird ein graduierter Anstieg der Härte erzeugt und gleichzeitig erfolgt auch innerhalb der Phasengradientenschicht ein kontinuierlicher Übergang vom Eigenspannungszustand der TiN-Anbindungsschicht zur Ti₁₋ₓAlₓN-Deckschicht. Diese Eigenschaftsgradienten wirken sich günstig auf das Verschleißverhalten aus, so dass mit dem erfindungsgemäßen Schichtsystem überraschend hohe Zuwächse in der Verschleißfestigkeit gegenüber Schichtsystemen entsprechend dem Stand der Technik erzielt werden konnten.

Außerdem weist das erfindungsgemäße Schichtsystem aus Phasengradientenschicht und Ti₁₋ₓAlₓN-Hartstoffschicht durchgängig einen hohen Al-Gehalt auf, so dass gegenüber den aus US 6,040,012 und DE 699 15 866 T2 bekannten Konzentrationsgradientenschichten eine höhere Oxidations- und Verschleißbeständigkeit erzielt wird.

Zur Herstellung der hartstoffbeschichteten Körper beinhaltet die Erfindung ein Verfahren, das dadurch gekennzeichnet ist, dass auf den Körper zunächst mit einem industriellen CVD-Standardprozess eine Anbindungsschicht aus TiN, Ti(C,N) oder TiC aufgebracht, darauf die Phasengradientenschicht abgeschieden und darauf schließlich in bekannter Weise mittels CVD ohne Plasmaanregung eine oder mehrere ein- oder mehrphasige Ti₁₋ₓAlₓN-Hartstoffschichten abgeschieden werden, wobei die Abscheidung der Phasengradientenschicht mit einem CVD-Prozess mit kontinuierlich fallender Prozesstemperatur unter Verwendung eines Precursorgemisches aus TiCl₄, AlCl₃, NH₃ und/oder Hydrazin, vermischt mit H₂ und/oder N₂ durchgeführt wird.

Der CVD-Prozess zur Abscheidung der Phasengradientenschicht wird vorteilhaft mit einer Anfangstemperatur zwischen 900°C und 1050°C begonnen. Die Prozesstemperatur wird dann im Verlaufe des Abscheidungsprozesses kontinuierlich bis auf eine Endtemperatur zwischen 700°C und 890°C abgesenkt.

Der CVD-Prozess zur Abscheidung der Phasengradientenschicht wird vorzugsweise während einer Dauer von 1 min bis 60 min durchgeführt.

Dem Precursor/Gasgemisch zur Abscheidung der Phasengradientenschicht können vorteilhaft zusätzlich inerte Edelgase zugemischt werden.

Der CVD-Prozess zur Abscheidung der Phasengradientenschicht wird vorzugsweise bei einem Druck von 10² Pa bis 10⁵ Pa durchgeführt.

Das erfindungsgemäße Verfahren ist einfach realisierbar und ermöglicht durch die Anwendung eines definierten Temperaturregimes die Einstellung der für die Haftung optimalen Phasen. Der zur Erzeugung der Phasengradientenschicht notwendige Prozessschritt ist ohne Zusatzaufwand in den Gesamtprozess integrierbar und führt zu keiner Verlängerung des gesamten Beschichtungsprozesses.

### Ausführungsform der Erfindung

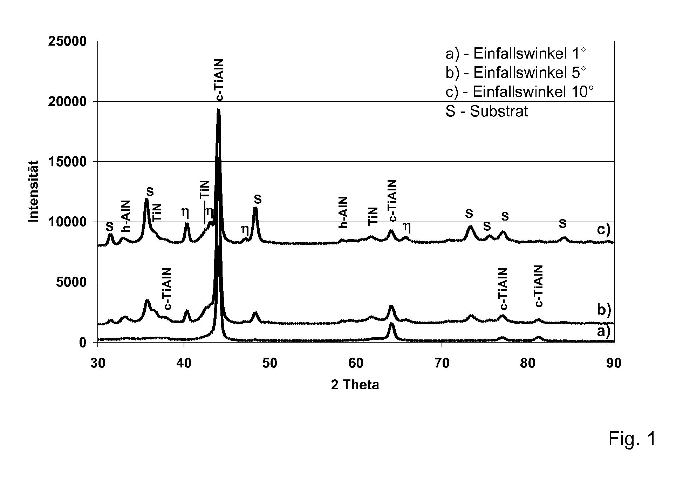

Nachstehend ist die Erfindung an einem Ausführungsbeispiel und der zugehörigen Fig. 1, die ein Röntgendifraktogramm zeigt, näher erläutert.

Auf WC/Co-Hartmetallwendeschneidplatten wird das erfindungsgemäße Schichtsystem in drei Prozessschritten mittels CVD aufgebracht. Im ersten Schritt erfolgt die Abscheidung einer dem Stand der Technik entsprechende Hochtemperatur TiN-Schicht mittels thermischer CVD. Dazu wird in einem Heißwand-CVD-Reaktor mit einem Innendurchmesser von 75mm eine Gasmischung aus 14 ml/min TiCl₄, 3000 ml/min H₂ und 300 ml/min N₂ bei einer Temperatur von 920°C und einem Druck von 9 kPa eingeleitet. Nach einer Beschichtungszeit von 60 min wird eine 1 µm dicke TiN-Anbindungsschicht erhalten.

Im zweiten Prozessschritt wird die Phasengradientenschicht erzeugt. Der Druck wird auf 0,5 kPa verringert und die Gasflüsse zur Abscheidung der Gradientenschicht eingestellt. Die Einspeisung der Gasmischung in den Reaktor erfolgt über zwei Gaswege, wobei die Mischung der beiden Gasströme 10 cm vor der Beschichtungszone erfolgt. Über den ersten Gaskanal werden 7 ml/min AlCl₃, 4 ml/min TiCl₄, 500 ml/min H₂ und 200 ml/min Ar zudosiert und über die zweite Gaszuführung erfolgt die Zugabe eines Gemisches aus 50 ml/min NH₃ und 250 ml/min N₂. Nach erfolgter Einstellung dieser Gasmischung wird die Abscheidungstemperatur in einer Zeit von 10 min von 920°C auf 850°C verringert. Dadurch bildet sich eine ca. 1 µm dicke Phasengradientenschicht, die aus den Phasen TiN, h-AlN und fcc-Ti₁₋ₓAlₓN besteht. Diese Phasengradientenschicht weist eine hohe Haftfestigkeit sowohl zur unteren TiN-Schicht als auch zur nachfolgenden fcc-Ti₁₋ₓAlₓN-Deckschicht auf.

Im dritten Prozessschritt wird dann bei 850°C und unveränderter Zusammensetzung der Gasmischung in 30min eine 3 µm dicke fcc-Ti₁₋ₓAlₓN-Schicht aufgebracht.

Die Zusammensetzung der Phasengradientenschicht wurde mittels röntgenographischer Dünnschichtanalyse im streifenden Einfall ermittelt. Die Ergebnisse sind aus dem Röntgendiffraktogramm gemäß Fig. 1 ersichtlich. Dabei wurde durch Messungen bei verschiedenen Einfallswinkeln die Veränderung der Phasenzusammensetzung mit zunehmender Schichtdicke erfasst. Die Messung erfolgte bei drei Einfallswinkeln. Beim kleinsten Einfallswinkel von 1 ° wird nur die oberste TiAIN-Schicht durchstrahlt. Die im Diffraktogramm auftretende Phase ist reines fcc-Ti₁₋ₓAlₓN. Bei einem Einfallswinkel von 5° wird auch der Bereich der darunterliegenden Gradientenschicht erfasst. Es sind Reflexe von fcc-Ti₁₋ₓAlₓN, h-AlN und TiN neben ersten Reflexen des Substrates WC/Co zu erkennen. Bei einem Winkel von 10° durchdringt die Röntgenstrahlung das gesamte Schichtsystem und Bereiche des Substrates. Im Diffraktogramm sind deshalb sowohl die Reflexe von fcc-Ti₁₋ₓAlₓN, h-AlN und TiN als auch die des Substrates zu erkennen.

Eine Verbesserung der Schichthaftung konnte im Ritztest nachgewiesen werden. Für ein konventionelles Zweischichtsystem aus TiN und fcc-Ti₁₋ₓAlₓN ohne Phasengradientenschicht wurde eine kritische Last von 60 N gemessen. Im Vergleich dazu erreicht das erfindungsgemäße Dreischichtsystem mit Phasengradientenschicht eine kritische Last von 100 N und weist damit eine deutlich höhere Haftfestigkeit auf.

Das erfindungsgemäße Schichtsystem besitzt eine erhöhte Verschleißfestigkeit im Vergleich zu TiAIN-Schichten, die entsprechend dem Stand der Technik hergestellt wurden. Beim Fräsen von Stahl 42 Cr Mo 4 V (Schnittgeschwindigkeit v_{c} = 250m/min, Schnitttiefe aₚ = 2mm , Vorschub f = 0,25mm) wurde für ein CVD-Zweischichtsystem aus 1 µm TiN und 3 µm TiAlN ein Standweg von 4000 mm ermittelt. Ein weiteres dem Stand der Technik entsprechendes PVD-TiAIN-Schichtsystem erreichte einen Standweg von 10 000mm. Das erfindungsgemäße Schichtsystem mit integrierter Phasengradientenschicht zeigte die höchste Verschleißfestigkeit und erzielte einen Standweg von durchschnittlich 12 000 mm.

## Patentansprüche

1. Hartstoffbeschichtete Körper mit einem mehrlagigen Schichtsystem, das eine auf den Körper aufgebrachte Anbindungsschicht aus TiN, Ti(C,N) oder TiC und mindestens eine ein- oder mehrphasige Ti₁₋ₓAlₓN-Hartstoffschicht enthält, **gekennzeichnet durch** eine zwischen der Anbindungsschicht und der Hartstoffschicht vorhandene Phasengradientenschicht, die an ihrer der Anbindungsschicht zugewandten Seite aus einem TiN/h-AIN-Phasengemisch besteht und in Richtung zur/zu den Ti₁₋ₓAlₓN-Hartstoffschicht(en) mit zunehmender Schichtdicke einen zunehmenden Phasenanteil von fcc-TiAIN mit einem Anteil von > 50% und damit einhergehender simultaner Abnahme der Phasenanteile von TiN und h-AlN aufweist.

2. Hartstoffbeschichtete Körper nach Anspruch 1, **dadurch gekennzeichnet, dass** die mehrphasigen Ti₁₋ₓAlₓN-Hartstoffschichten als Hauptphase fcc-Ti₁₋ₓAlₓN enthalten, wobei als weitere Phasen Ti₁₋ₓAlₓN in Wurtzitstruktur und/oder TiN enthalten sind.

3. Hartstoffbeschichtete Körper nach Anspruch 1, **dadurch gekennzeichnet, dass** die Phasengradientenschicht über ihre Dicke einen konstanten oder nahezu konstanten Gehalt an Ti, Al und N aufweist.

4. Hartstoffbeschichtete Körper nach Anspruch 1, **dadurch gekennzeichnet, dass** die Schichtdicke der Phasengradientenschicht 0,1 µm bis 5 µm beträgt.

5. Hartstoffbeschichtete Körper nach Anspruch 1, **dadurch gekennzeichnet, dass** das Atomverhältnis von Ti:Al in der Phasengradientenschicht im Bereich von 1:1 bis 1:15 liegt.

6. Verfahren zur Herstellung hartstoffbeschichteter Körper nach einem der Ansprüche 1 bis 5, **dadurch gekennzeichnet, dass** auf den Körper zunächst mit einem industriellen CVD-Standardprozess eine Anbindungsschicht aus TiN, Ti(C,N) oder TiC aufgebracht, darauf die Phasengradientenschicht abgeschieden und darauf schließlich in bekannter Weise mittels CVD ohne Plasmaanregung eine oder mehrere ein- oder mehrphasige Ti₁₋ₓAlₓN-Hartstoffschichten abgeschieden werden, wobei die Abscheidung der Phasengradientenschicht mit einem CVD-Prozess mit kontinuierlich fallender Prozesstemperatur unter Verwendung eines Precursorgemisches aus TiCl₄, AlCl₃, NH₃ und/oder Hydrazin, vermischt mit H₂ und/oder N₂ durchgeführt wird.

7. Verfahren nach Anspruch 6, **dadurch gekennzeichnet, dass** der CVD-Prozess zur Abscheidung der Phasengradientenschicht mit einer Anfangstemperatur zwischen 900°C und 1050°C begonnen wird und dass die Prozesstemperatur im Verlaufe des Abscheidungsprozesses kontinuierlich bis auf eine Endtemperatur zwischen 700°C und 890°C abgesenkt wird.

8. Verfahren nach Anspruch 6, **dadurch gekennzeichnet, dass** der CVD-Prozess zur Abscheidung der Phasengradientenschicht während einer Dauer von 1 min bis 60 min durchgeführt wird.

9. Verfahren nach Anspruch 6, **dadurch gekennzeichnet, dass** dem Precursor/Gasgemisch zur Abscheidung der Phasengradientenschicht zusätzlich inerte Edelgase zugemischt werden.

10. Verfahren nach Anspruch 6, **dadurch gekennzeichnet, dass** der CVD-Prozess zur Abscheidung der Phasengradientenschicht bei einem Druck von 10² Pa bis 10⁵ Pa durchgeführt wird.

## Claims

1. Bodies which are coated with hard material and have a multilayer layer system containing a bonding layer composed of TiN, Ti(C,N) or TiC applied to the body and at least one single-phase or multiphase Ti₁₋ₓAlₓN hard material layer, **characterized by** a phase gradient layer which is present between the bonding layer and the hard material layer and on its side facing the bonding layer consists of a TiN/h-AlN phase mixture and in the direction to the Ti₁₋ₓAlₓN hard material layer(s) has an increasing phase content of fcc-TiAlN with a proportion of > 50% and, associated therewith, a simultaneous decrease in the phase contents of TiN and h-AlN with increasing layer thickness.

2. Bodies which are coated with hard material according to Claim 1, **characterized in that** the multiphase Ti₁₋ₓAlₓN hard material layers contain fcc-Ti₁₋ₓAlₓN as main phase, with Ti₁₋ₓAlₓN having the wurkzite structure and/or TiN being present as further phases.

3. Bodies which are coated with hard material according to Claim 1, **characterized in that** the phase gradient layer has a constant or virtually constant content of Ti, Al and N over its thickness.

4. Bodies which are coated with hard material according to Claim 1, **characterized in that** the layer thickness of the phase gradient layer is from 0.1 µm to 5 µm.

5. Bodies which are coated with hard material according to Claim 1, **characterized in that** the atom ratio of Ti:Al in the phase gradient layer is in the range from 1:1 to 1:15.

6. Process for producing bodies which are coated with hard material according to any of Claims 1 to 5, **characterized in that** a bonding layer composed of TiN, Ti(C,N) or TiC is firstly applied to the body by means of an industrial standard CVD process, the phase gradient layer is deposited thereon and one or more single-phase or multiphase Ti₁₋ₓAlₓN hard material layers are finally deposited thereon in a known manner by means of CVD without plasma excitation, with the deposition of the phase gradient layer being carried out by means of a CVD process with a continuously decreasing process temperature using a precursor mixture of TiCl₄, AlCl₃, NH₃ and/or hydrazine, mixed with H₂ and/or N₂.

7. Process according to Claim 6, **characterized in that** the CVD process for the deposition of the phase gradient layer is commenced at an initial temperature in the range from 900°C to 1050°C and **in that** the process temperature is decreased continuously during the course of the deposition process to a final temperature in the range from 700°C to 890°C.

8. Process according to Claim 6, **characterized in that** the CVD process for the deposition of the phase gradient layer is carried out from a time of from 1 minute to 60 minutes.

9. Process according to Claim 6, **characterized in that** inert noble gases are additionally mixed into the precursor/gas mixture for the deposition of the phase gradient layer.

10. Process according to Claim 6, **characterized in that** the CVD process for the deposition of the phase gradient layer is carried out at a pressure of from 10² Pa to 10⁵ Pa.

## Revendications

1. Corps recouverts d'une substance dure, comprenant un système multicouche, qui contient une couche de liaison en TiN, Ti(C,N) ou TiC appliquée sur les corps, et au moins une couche de substance dure mono- ou multiphasée en Ti₁₋ₓAlₓN, **caractérisés par** une couche à gradient de phases présente entre la couche de liaison et la couche de substance dure, qui est constituée sur son côté orienté vers la couche de liaison d'un mélange de phases TiN/h-AlN et qui présente, lorsque l'épaisseur de couche augmente dans la direction de la ou des couches de substance dure en Ti₁₋ₓAlₓN, une proportion croissante de phase fcc-TiAlN en une proportion > 50 % et par conséquent un déclin simultané des proportions des phases TiN et h-AlN.

2. Corps recouverts d'une substance dure selon la revendication 1, **caractérisés en ce que** les couches de substance dure en Ti₁₋ₓAlₓN multiphasées contiennent en tant que phase principale fcc-T₁₋ₓAlₓN ; Ti₁₋ₓAlₓN en structure wurtzite et/ou TiN étant contenus en tant qu'autres phases.

3. Corps recouverts d'une substance dure selon la revendication 1, **caractérisés en ce que** la couche à gradient de phases présente sur son épaisseur une teneur constante ou presque constante en Ti, Al et N.

4. Corps recouverts d'une substance dure selon la revendication 1, **caractérisés en ce que** l'épaisseur de couche de la couche à gradient de phases est de 0,1 µm à 5 µm.

5. Corps recouverts d'une substance dure selon la revendication 1, **caractérisés en ce que** le rapport atomique Ti:Al dans la couche à gradient de phases se situe dans la plage allant de 1:1 à 1:15.

6. Procédé de fabrication de corps recouverts d'une substance dure selon l'une quelconque des revendications 1 à 5, **caractérisé en ce qu'**une couche de liaison en TiN, Ti(C,N) ou TiC est tout d'abord appliquée sur les corps par un procédé CVD industriel standard, sur laquelle la couche à gradient de phases est déposée, et sur laquelle une ou plusieurs couches de substance dure en Ti₁₋ₓAlₓN mono- ou multiphasées sont enfin déposées d'une manière connue par CVD sans excitation plasma, le dépôt de la couche à gradient de phases étant réalisé par un procédé CVD à une température de procédé qui chute en continu, en utilisant un mélange précurseur constitué de TiCl₄, AlCl₃, NH₃ et/ou d'hydrazine, mélangé avec H₂ et/ou N₂.

7. Procédé selon la revendication 6, **caractérisé en ce que** le procédé CVD pour le dépôt de la couche à gradient de phases est débuté avec une température initiale comprise entre 900 °C et 1 050 °C, et **en ce que** la température de procédé est diminuée en continu au cours du procédé de dépôt jusqu'à une température finale comprise entre 700 °C et 890 °C.

8. Procédé selon la revendication 6, **caractérisé en ce que** le procédé CVD pour le dépôt de la couche à gradient de phases est réalisé pendant une durée de 1 minute à 60 minutes.

9. Procédé selon la revendication 6, **caractérisé en ce que** des gaz nobles inertes sont également incorporés dans le précurseur/mélange gazeux pour le dépôt de la couche à gradient de phases.

10. Procédé selon la revendication 6, **caractérisé en ce que** le procédé CVD pour le dépôt de la couche à gradient de phases est réalisé à une pression de 10² Pa à 10⁵ Pa.
